(19) Europäisches Patentamt
European Patent Office
Office européen des brevets

(11) Publication number: **0 267 540 B1**

# (12) EUROPEAN PATENT SPECIFICATION

(45) Date of publication of patent specification: **14.04.93** (51) Int. Cl.[5]: **G03F 7/42**

(21) Application number: **87116317.6**

(22) Date of filing: **05.11.87**

## (54) Stripping compositions and their use for stripping resists from substrates.

(30) Priority: **10.11.86 US 929408**

(43) Date of publication of application:
**18.05.88 Bulletin 88/20**

(45) Publication of the grant of the patent:
**14.04.93 Bulletin 93/15**

(84) Designated Contracting States:
**AT BE CH DE ES FR GB IT LI LU NL SE**

(56) References cited:
**EP-A- 0 145 973**
**US-A- 4 395 479**

**PATENT ABSTRACTS OF JAPAN, vol. 11, no. 236 (P-601)[2683], 4th August 1987 & JP-A-62 49 355 (NAGASE SANGYO K.K.) 04-03-1987**

**IBM TECHNICAL DISCLOSURE BULLETIN, vol. 29, no. 5, October 1986, page 1932, New York, US; "Photoresist removal by nucleophilic agents in organic solvents"**

(73) Proprietor: **J.T. BAKER INC.**
**222 Red School Lane**
**Phillipsburg New Jersey 08865(US)**

(72) Inventor: **Ramsden, Hugh E.**
**2080 Wood Road**
**Scotch Plains New Jersey 07076(US)**
Inventor: **Ward, Dawn L.**
**2204 Treeline Drive**
**Easton Pennsylvania 18042(US)**

(74) Representative: **Vossius & Partner**
**Siebertstrasse 4 P.O. Box 86 07 67**
**W-8000 München 86 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.5x/3.0.1)

## Description

This invention relates to novel photoresist stripping compositions as defined in the preamble of claim 1 and to their use for stripping an unexposed photoresist.

Modern technology utilizes positive-type resist materials for lithographically delineating patterns onto a substrate so that the patterns can be subsequently etched or otherwise defined into the substrate material. The resist material is deposited as a film and the desired pattern is defined by exposing the resist film to energetic radiation. Thereafter the exposed regions are subject to a dissolution by a suitable developer liquid. After the pattern has been thus defined in the substrate, the resist material must be completely removed from the substrate to avoid adversely affecting or hindering subsequent operations or processing steps.

It is necessary in such a photolithographic process that the photoresist material, following pattern delineation, be evenly and completely removed from all unexposed areas so as to permit further lithographic operations. Even the partial remains of a resist in an area to be further patterned is undesirable. Also, undesired resist residues between patterned lines can have deleterious effects on subsequent processes, such as metallization, or cause undesirable surface states and charges.

Heretofore the resist materials have been removed by stripping agents containing one or more of the following: halogenated hydrocarbons, for example, methylene chloride or tetrachloroethylene; amines and their derivatives such as dimethylformamide, N-methyl-2-pyrrolidone, diethanolamine and triethanolamine; glycol ethers such as ethylene glycol monoethyl ether, 2-butoxyethanol, 2-(2-butoxyethoxy)ethanol, and the acetates thereof; ketones such as methyl ethyl ketone, acetone, methyl isobutyl ketone and cyclohexanone, as well as such materials as dioxane, sodium phenolate, isopropyl alcohol, sulfuric acid/nitric acid mixtures, persulfuric acid mixtures such as Caro's acid and sulfuric acid/ammonium persulfate, and mixtures of caustic and phenol derivatives as well as various other materials.

However, there are various and numerous drawbacks and disadvantages with these various materials. Among the one or more drawbacks and disadvantages found in the use of each such stripping agents there may be mentioned the following: undesirable flammability, volatility, odor and toxicity; incomplete removal of all resist film; effectiveness only on certain resist films; attack of components other than the resist material, such as attack of metal substrates by the stripping agent; safety in handling and disposal of the stripper; and the undesired necessity for use at specified elevated temperatures when selected resists are being stripped. Furthermore, the limited stripping capabilities of the stripping agents is a very decided drawback. Additionally, many such strippers are not sufficiently effective against resist materials that are subject to a severe post-baking operation thereby limiting their usefulness. In some of the strippers the presence of water is extremely detrimental. Additionally, for those stripping applications requiring inertness of the agent to metal substrates, toxicity during handling and difficulty of disposal are primary drawbacks.

More recently it has been discovered that greatly improved stripping compositions are provided from a mixture of a 2-pyrrolidinone compound and a tetrahydrothiophenel-1,1-dioxide compound which mixture preferably also includes a polyethylene glycol and/or a diethylene glycol monoalkyl ether. Such stripping compositions are disclosed, for example, in U.S. Patent 4,395,479, issued July 26, 1983 to I. Ward et al and assigned to J. T. Baker Chemical Company. While such stripping compositions represent a significant advance in the art and eliminated or substantially reduced many of the drawbacks and disadvantages with previously used compositions, there is still a great need for even more effective stripping compositions. Moreover, while the stripping compositions of the Ward et al patent are generally effective in removing resist compositions from substrates which had been subjected to post-baking at 150 °C for periods of up to 1 hour, it has become highly desirable and necessary to provide stripping compositions capable of readily removing photoresists from substrates subjected to higher post-baking temperatures, e.g. post-baking temperatures of 180° and 200 °C for 1 hour.

Additionally, with the introduction of new and materially different photoresist compositions, it has been discovered that stripping compositions that are effective in removing older and different photoresists were not always as effective or effective at all in removing the new photoresist compositions from substrates.

There is, therefore, a need for more effective and improved photoresist stripping compositions and particularly for such stripping compositions that will effectively and quickly remove new and improved photoresist compositions and also those that have been subjected to post-baking temperature of 150°, 180° and 200 °C.

This need is satisfied by the provision of the stripping composition in accordance with claim 1 and by its use in accordance with claim 6.

It has been found that a suitable improved photoresist stripping composition in which the hereinbefore mentioned disadvantages and drawbacks are eliminated or substantially reduced and in which the range of

usefulness of the stripping composition is greatly extended can be obtained in accordance with the teachings of the present invention. The novel stripping compositions also exhibit a synergistically enhanced stripping action and provide resist stripping capabilities not possible from the use of the individual components used alone as photoresist strippers. The novel stripping compositions of this invention comprise a mixture of from about 30 to about 76 percent by weight of a 2-pyrrolidinone compound, from about 10 to about 56 percent by weight of a tretrahydrothiophene-1,1-dioxide compound, from about 3 to about 20 percent by weight of polyethylene glycol, from about 10 to about 30 percent by weight of a diethylene glycol monoalkyl ether and from about 1 to about 15% by weight of certain amines or amine derivatives, preferably hydroxylated amine compounds. The presence of water in the stripping compositions of this invention is not detrimental and can be present in an amount from about 0 to about 10 percent by weight without undue adverse effects resulting.

The invention also teaches the use of such stripping compositions for removing photoresist material from a substrate surface.

The stripping compositions of this invention comprise stripping compositions containing from about 30 to about 76 weight percent, preferably from about 45 to about 70 weight percent and more preferably from about 45 to about 60 weight percent of a 2-pyrrolidinone compound of the general formula:

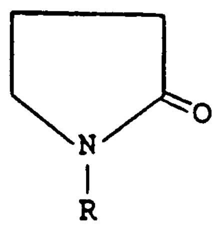

wherein R is hydrogen, alkyl of 1 to 3 carbon atom or hydroxyalkyl of 1 to 3 carbon atoms; from about 10 to about 56 weight percent, preferably from about 10 to about 40 weight percent and more preferably about 15 to about 30 weight percent of a tetrahydrothiophene-1,1-dioxide compound of the general formula:

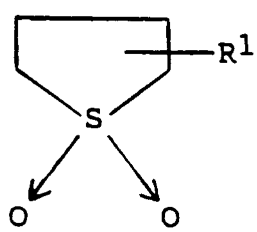

wherein $R^1$ is hydrogen, methyl or ethyl; from about 3 to about 20 weight percent, preferably about 5 to about 12 weight percent, and most preferably about 7 to about 12 weight percent polyethylene glycol; from about 10 to about 30 weight percent, preferably from about 12 to about 20 weight percent and most preferably about 15 to about 20 weight percent of a diethylene glycol monoalkyl ether and from about 1 to about 15 weight percent, preferably from about 2 to about 10 weight percent and most preferably from about 3 to about 10 of an amine or amine derivative selected from the group consisting of 3-amino-1-propanol, ethanolamine, 2(2-aminoethylamino)ethanol, 2-amino-2-methyl-1-propanol, isopropanolamine, 2-amino-3-picoline, 2-amino-4-nitrophenol, 2-amino-6-picoline, morpholine, 2-aminoethylpiperazine and 2-amino-4,6-dimethyl pyrimidine.

The diethylene glycol monoalkyl ethers that may be employed in the compositions of this invention are those of the formula $HOCH_2CH_2\text{-}O\text{-}CH_2CH_2\text{-}O\text{-}R^2$ wherein $R^2$ is alkyl of 1 to 4 carbon atoms. Examples of such compounds for use in the compositions of this invention are, for example, the monomethyl-, monoethyl-, and monobutylethers of diethylene glycol. Especially preferred is 2-(2-ethoxyethoxy)ethanol.

In the stripping compositions of this invention any suitable polyethylene glycol may be employed although polyethylene glycol of a molecular weight of about 200 is preferred.

While the stripping compositions of this invention can be free of water, this is not essential and water can be present in an amount of up to about 10 percent by weight.

Preferred compositions of this invention are those containing from about 45 to 60 weight percent pyrrolidinone compound, from about 15 to 30 weight percent tetrahydrothiophene-1,1-dioxide compound, from about 6 to 12 weight percent polyethylene glycol, from about 15 to 20 weight percent diethylene glycol monoalkyl ether and from about 3 to 10 weight percent of the amine or amine derivative.

As exemplary stripping compositions of this invention there can be mentioned the following compositions of Table I.

TABLE 1

| Component | Composition - Percents by Weight | | | | | | |
|---|---|---|---|---|---|---|---|
| | A | B | C | D | E | F | G |
| 1-methyl-2-pyrrolidinone | 48 | 45 | 53 | 50 | 53 | 50 | 48 |
| tetrahydrothiophene-1,1-dioxide | 24 | 22 | 15 | 13 | 15 | 13 | 24 |
| 2-(2-ethoxyethoxy)ethanol | 13 | 12 | 19 | 18 | 10 | 9 | 13 |
| polyethylene glycol (200) | 12 | 11 | 10 | 9 | 19 | 18 | 12 |
| 1-amino-2-propanol | 3 | 10 | -- | -- | -- | -- | -- |
| ethanolamine | -- | -- | 3 | 10 | -- | -- | -- |
| 2-(2-aminoethylamino)ethanol | -- | -- | -- | -- | 3 | 10 | -- |
| 2-amino-2-methyl-1-propanol | -- | -- | -- | -- | -- | -- | 3 |

The stripping compositions of this invention are effective in stripping a wide and varied range of positive photoresists. Most positive photoresists consist of an ortho napthoquinone diazide sulfonic acid ester or amide sensitizer or photoactive component, with novolak, resole, polyacrylamide or acrylic copolymer type binders or resins. Such positive photoresists are well known in the art. Such resists and sensitizers are described, for example, in U.S. Patent Nos. 3,046,118; 3,046,121; 3,106,465; 3,201,239; 3,538,137; 3,666,473; 3,934,057; 3,984,582 and 4,007,047. As examples of such positive photoresist compositions for which the stripping composition of this invention may be used, there may be mentioned Eastman Kodak Company photoresist Kodak 809; J. T. Baker Chemical Company photoresist 1PR-21, 1PR-5, 1PR-25 and 1PR-95; Philip A. Hunt Chemical Corporation Waycoat HPR 104, HPR 106, HPR 204 and HPR 206 photoresists; American Hoechst Corporation photoresists AZ-1350, AZ-1350B, AZ-1350H, AZ-1350J, AZ-1370, AZ-1450B, AZ-1450J, AZ-1470, AZ-2400, AZ-111, AZ-1375, AZ-1350B-SF, AZ-1350J-SF and AZ-1370-SF; Polychrome Corporation photoresists PC-129, PC-129SF and PC-138; Fuju Chemical Industrial Company photoresist FPR-200; Dynachem Corporation photoresist OFPR-800; and Mac Dermid, Inc. photoresists Ultramac UM-74, PR 913, PR 914 and PR 915.

The stripping compositions of this invention are effective in completely removing photoresist materials from substrates even when they have been subjected to a post-bake treatment at about 150°, 180° or 200°C for a period of about one hour.

The stripping compositions of this invention are especially advantageous for numerous reasons among which may be mentioned the following. The stripping compositions remove positive photoresist material from metal and other substrates without attacking the substrate. The compositions are essentially non-toxic and are water miscible. The presence of water during the stripping operation is not deleterious to the operation of the stripping composition. Unlike phenolic based strippers, the compositions of this invention require no special handling and are easily disposed of in normal sewage treatment facilities. Moreover, the bath life and stripping effectiveness of the compositions are for the most part independent of temperature. Use of the stripping compositions of this invention requires only a subsequent rinse with deionized water whereas many prior strippers require the use of additional organic solvents. The stripping compositions of

this invention completely remove difficult-to-remove positive photoresist at about 75°C to 95°C or less whereas some prior art strippers require bath temperatures of about 95° to 100°C or more. Also, most positive photoresists are completely stripped in about five minutes or less while stripping times of up to 20 minutes are recommended for many commercial stripping compositions.

It has been unexpectedly found that the stripping compositions of this invention containing an amine or amine derivative component effectively and completely remove positive photoresist material from substrates from which photoresist materials are not effectively and completely removed by the compositions of prior U.S. Patent 4,395,479.

The effectiveness and unexpected nature of the stripping action of stripping composition of this invention is illustrated by the data presented in the following Examples.

Wafer substrates (approximately 3") were coated with a 1 micron coating of positive photoresist material according to art recognized procedures and post-baked at about 150°C for a period of about one hour. Stripping baths were maintained at equal constant temperature with water baths and the post-baked coated wafers were immersed into 600 ml beakers containing the constant temperature stripping compositions with intermittent agitation for identical time periods after which the wafers were removed, rinsed in running deionized water and dried in a stream of nitrogen. Strippability was judged by inspection of the wafers to ascertain resist remove.

Compositions of this invention, denoted as Examples 1 through 11 in Table II hereinafter, were compared to stripping results obtained for the preferred composition of previously mentioned U.S. Patent 4,395,479, denoted as Control A. The composition of Control A is as follows: 51% by weight 1-methyl-2-pyrrolidinone, 26% by weight tetrahydrothiophene-1,1-dioxide, 17% by weight 2-(2-ethoxyethoxy)ethanol, and 6% by weight polyethylene glycol. Examples 1 through 11 contain 97% by weight of Control A plus 3% by weight of the specified amine or amine derivative. The stripping compositions were employed to remove generally difficult to remove photoresists, namely American Hoechst Corporation's AZ-2400 and AZ-1450J photoresists, J. T. Baker Chemical Company's 1PR-21 photoresist, Dynachem's OFPR-800 photoresist and Mac Dermid's UM-74 photoresist.

TABLE II

| Example No. | Components |
|---|---|
| 1 | Control A + 3-amino-1-propanol |
| 2 | Control A + ethanolamine |
| 3 | Control A + 2(2-aminoethylamino)ethanol |
| 4 | Control A + 2-amino-2-methyl-1-propanol |
| 5 | Control A + DL-1-amino-2-propanol |
| 6 | Control A + 2-amino-6-picoline |
| 7 | Control A + morpholine |
| 8 | Control A + 2-aminoethylpiperazine |
| 9 | Control A + 2-amino-4,6-dimethyl pyridine |
| 10 | Control A + 2-amino-2-picoline |
| 11 | Control A + 2-amino-4-nitrophenol. |

Each of the compositions of this invention, Examples 1 to 11, produced more effective photoresist stripping then the comparative composition of U.S. Patent 4,395,479, Control A, alone.

Further testing of compositions of this invention demonstrated their greatly improved photoresist stripping ability compared to a composition of U.S. Patent 4,395,479, i.e. Control A as set forth hereinbefore, especially for stripping photoresist from coated substrates subjected to post-baking temperatures of 180° and 200°C as well as at 150°C. Exemplary of such improved stripping of photoresist from substrates is that illustrated hereinafter in Examples 13 to 15. The compositions employed in Examples 13 to 15 are Compositions A through F set forth in Table III.

TABLE II

| Composition | Components |
|---|---|
| A | Control A 97% + ethanolamine 3% |
| B | Control A 90% + ethanolamine 10% |
| C | Control A 97% + 2-(2-aminoethylamino)ethanol 3% |
| D | Control A 90% + 2-(2-aminoethylamino)ethanol 10% |
| E | Control A 97% + DL-1-amino-2-propanol 3% |
| F | Control A 90% + DL-1-amino-2-propanol 10% |

The stripping compositions, Compositions A through F as well as Control A alone, were employed to remove the difficult to remove photoresists AZ-1450J, 1PR-21, OFPR-800 and UM-74 employed in Examples 1 to 11. The same general procedure employed in Examples 1 to 11 was employed in Examples 13 to 15 except that the post-bake treatment temperature, stripping bath temperature and immersion periods, were as indicated in the Examples. In the Examples 13 to 15 acceptable removal of the photoresist is indicated by R and non-removal of photoresist by NR.

## EXAMPLE 13

Photoresists coated wafers were post-baked at 150°C for 1 hour, stripping bath temperature was 75°C and immersion time of wafers in the stripping bath was 5 minutes.

| | | Stripping Composition | | | |
|---|---|---|---|---|---|
| Photoresist | Control A | A | C | E | F |
| AZ-1450J | R | R | R | R | R |
| 1PR-21 | NR | R | R | R | R |
| OFPR-800 | NR | R | R | R | R |
| UM-74 | NR | R | R | R | R |

## EXAMPLE 14

Photoresist coated wafers were post-baked at 180°C for 1 hour, stripping bath temperature was 75° or 95° C (as indicated) and immersion time of wafers in the stripping bath was 5 minutes.

| Photoresist | Control A | Stripping Composition A | B | C | D | E | F |
|---|---|---|---|---|---|---|---|
| 1PR-21 | 95°-NR | 75°-R | 75°-R | 75°-R | 75°-R | 75°-R | 75°-R |
| UM-74 | 95°-NR | 95°-NR | 95°-NR | 95°-R | 95°-R | 95°-R | 75°-R |
| AZ-1450J | 95°-NR | 95°-R | 95°-R | --- | --- | 95°-R | 75°-R |
| OFPR-800 | 95°-NR | 95°-NR | 95°-R | 95°-R | --- | 95°-R | 75°-R |

**EXAMPLE** 15

Photoresist coated wafers were post-baked at 200 ° C for 1 hour, stripping bath temperature was 75 ° or 95 ° C (as indicated) and immersion time of wafers in the stripping bath was 5 minutes.

| Photoresist | Control A | Stripping Composition E | F |
|---|---|---|---|
| 1PR-21 | 95°-NR | 95°-R | 75°-R |
| UM-74 | 95°-NR | 75°-R | 75°-R |
| AZ-1450J | 95°-NR | 95°-R | 95°-R |
| OFPR-800 | 95°-NR | 95°-R | 95°-R |

Examples 13 to 15 demonstrate that the improved stripping compositions of this invention strip photoresists from substrates which have been post-baked at 150 °, 180 ° and 200 ° C while the prior art composition of U.S. 4,395,479 (Control A) does not. Furthermore, in many cases the improved stripping compositions of this invention are able to strip photoresist from substrates at a lower temperature thus permitting improved stripping efficiency.

The stripping results obtained with the improved stripping compositions of this invention were unexpected since many other similar amines or amine derivatives do not produce such improved photoresist stripping when added to Control A composition of U.S. 4,395,479. For example, when about 3% or 6% by weight of the following listed amines or amine derivatives are added to Control A and tested in the same manner as described in connection with Examples 1 to 12, there is no improvement and in some cases a detrimental decrease in stripping ability compared to Control A alone: 4-methyl morpholine-N-oxide, 3,4 xylidene, N-(3-aminopropyl)diethanolamine, triethylene tetramine, aminomethyl-3,5,5-trimethylcyclohexane, 1,8-diamino-p-menthane, dodecylamine, 4-butylaniline, 4-aminophenyl sulfone, diisopropanolamine, 2-(tertbutylamino)ethanol, 2-(diisopropylamino)ethanol, benzyltrimethyl ammonium hydroxide and polyethyleneimine (MW 50,000).

It is anticipated that the stripping compositions of this invention can be used as stripping agents for positive photoresists by contacting the unexposed photoresist on a substrate with the stripping composition in a variety of means, such as by immersion in a stripping bath or by spraying the stripping composition over the surface of the unexposed photoresist.

While the use of the above compositions for stripping photoresist materials from substrates has alone been illustrated, it will be appreciated that the stripping compositions of the invention are suitable for other uses which will be apparent to those skilled in the art, such as, for example, in the stripping of polymer residues from reaction or curing vessels and the like, or for stripping coatings, such as for example, paints and varnishes and the like, from surfaces.

## Claims

1. A stripping composition comprising from about 30 to about 76 weight percent of a 2-pyrrolidinone compound of the formula:

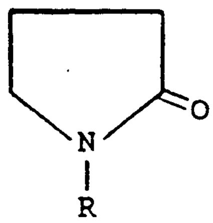

wherein R is selected from the group consisting of hydrogen, alkyl of 1 to 3 carbon atoms and hydroxyalkyl of 1 to 3 carbon atoms; from about 10 to about 56 weight percent of a tetrahydrothiophene-1,1-dioxide compound of the formula:

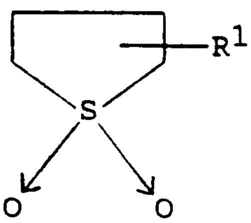

wherein $R^1$ is selected from the group consisting of hydrogen, methyl or ethyl; from about 3 to about 20 weight percent polyethylene glycol; from about 10 to about 30 weight percent of a diethylene glycol monoalkyl ether of the formula: $HOCH_2CH_2\text{-}O\text{-}CH_2CH_2\text{-}O\text{-}R^2$ wherein $R^2$ is alkyl of 1 to 4 carbon atoms; characterized in that it further comprises from about 1 to about 15 weight percent of an amine or amine derivative selected from the group consisting of 3-amino-1-propanol, ethanolamine, 2(2-aminoethylamino)ethanol, 2-amino-2-methyl-1-propanol, isopropanolamine, 2-amino-3-picoline, 2-amino-4-nitrophenol, 2-amino-6-picoline, morpholine, 2-aminoethylpiperazine and 2-amino-4,6-dimethyl pyrimidine.

2. A composition according to Claim 1 characterized by comprising from about 45 to about 70 weight percent 2-pyrrolidinone compound, from about 10 to about 40 weight percent tetrahydrothiophene-1,1-dioxide compound, from about 5 to about 12 weight percent polyethylene glycol, from about 12 to about 20 weight percent diethylene glycol monoalkyl ether compound and from about 2 to about 10 weight percent of amine or amine derivative.

3. A composition according to Claim 1 characterized by comprising from about 45 to about 60 weight percent 2-pyrrolidinone compound, from about 15 to about 30 weight percent tetrahydrothiophene-1,1-dioxide compound, from about 6 to about 12 weight percent polyethylene glycol, from about 15 to about 20 weight percent diethylene glycol monoalkyl ether compound and from about 3 to about 10 weight percent of amine or amine derivative.

4. A composition according to one of the preceding claims, characterized in that the 2-pyrrolidinone compound is 1-methyl-2-pyrrolidinone, the tetrahydrothiophene-1,1-dioxide compound is tetrahydrothiophene-1,1-dioxide, the diethylene glycol monoalkyl ether compound is 2-(2-ethoxyethoxy)-ethanol and the amine or amine derivative compound is selected from the group consisting of 1-amino-2-propanol, ethanolamine and 2-(2-aminoethylamino)ethanol.

5. A composition according to any of Claims 4 or 5 wherein the polyethylene glycol is polyethylene glycol of a molecular weight of about 200.

6. Use of the stripping composition according to any of the preceding claims for stripping an unexposed photoresist from a substrate by contacting the unexposed photoresist with said stripping composition.

## Patentansprüche

1. Abstreifmittel, umfassend etwa 30 bis etwa 76 Gew.-% einer 2-Pyrrolidinonverbindung der Formel:

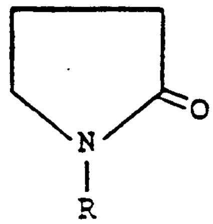

in der R ausgewählt ist aus der Gruppe Wasserstoffatom, Alkylrest mit 1 bis 3 Kohlenstoffatomen und Hydroxyalkylrest mit 1 bis 3 Kohlenstoffatomen; etwa 10 bis etwa 56 Gew.-% einer Tetrahydrothiophen-1,1-dioxidverbindung der Formel

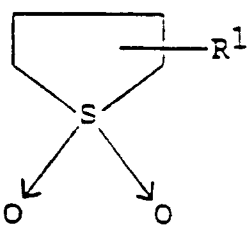

in der $R^1$ ausgewählt ist aus der Gruppe Wasserstoffatom, Methyl- oder Ethylgruppe; etwa 3 bis etwa 20 Gew.-% Polyethylenglykol; etwa 10 bis etwa 30 Gew.-% eines Diethylenglykolmonoalkylethers der Formel: $HOCH_2CH_2$-O-$CH_2CH_2$-O-$R^2$, in der $R^2$ einen Alkylrest mit 1 bis 4 Kohlenstoffatomen darstellt; dadurch gekennzeichnet, daß es weiterhin etwa 1 bis etwa 15 Gew.-% eines Amins oder Aminderivats aus der Gruppe 3-Amino-1-propanol, Ethanolamin, 2-(2-Aminoethylamino)ethanol, 2-Amino-2-methyl-1-propanol, Isopropanolamin, 2-Amino-3-picolin, 2-Amino-4-nitrophenol, 2-Amino-6-picolin, Morpholin, 2-Aminoethylpiperazin und 2-Amino-4,6-dimethylpyrimidin umfaßt.

2. Mittel nach Anspruch 1, dadurch gekennzeichnet, daß es etwa 45 bis etwa 70 Gew.-% 2-Pyrrolidinonverbindung, etwa 10 bis etwa 40 Gew.-% Tetrahydrothiophen-1,1-dioxid-Verbindung, etwa 5 bis etwa 12 Gew.-% Polyethylenglykol, etwa 12 bis etwa 20 Gew.-% Diethylenglykolmonoalkyletherverbindung und etwa 2 bis etwa 10 Gew.-% eines Amins oder eines Aminderivats umfaßt.

3. Mittel nach Anspruch 1, dadurch gekennzeichnet, daß es etwa 45 bis etwa 60 Gew.-% 2-Pyrrolidinonverbindung, etwa 15 bis etwa 30 Gew.-% Tetrahydrothiophen-1,1-dioxid-Verbindung, etwa 6 bis etwa 12 Gew.-% Polyethylenglykol, etwa 15 bis etwa 20 Gew.-% Diethylenglykolmonoalkyletherverbindung und etwa 3 bis etwa 10 Gew.-% eines Amins oder Aminderivats umfaßt.

4. Mittel nach einem der vorangehenden Ansprüche, dadurch gekennzeichnet, daß die 2-Pyrrolidinonverbindung 1-Methyl-2-pyrrolidinon ist, die Tetrahydrothiophen-1,1-dioxidverbindung Tetrahydrothiophen-1,1-dioxid ist, die Diethylenglykolmonoalkyletherverbindung 2-(2-Ethoxyethoxy)ethanol ist und das Amin oder die Aminderivatverbindung ausgewählt ist aus 1-Amino-2-propanol, Ethanolamin und 2-(2-Aminoethylamino)ethanol.

5. Mittel nach Anspruch 4, wobei das Polyethylenglykol ein Polyethylenglykol mit einem Molekulargewicht von etwa 200 ist.

6. Verwendung des Abstreifmittels nach einem der vorangehenden Ansprüche zum Abstreifen eines unbelichteten Photolacks auf einem Substrat durch Inkontaktbringen des unbelichteten Photolacks mit dem Abstreifmittel.

## Revendications

1. Une composition d'élimination comprenant d'environ 30 à environ 76 % en poids d'un dérivé de 2-pyrrolidinone de formule :

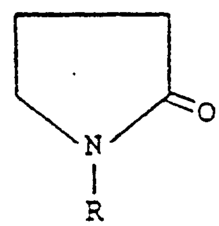

dans laquelle R est choisi parmi un atome d'hydrogène, un groupe alkyle en $C_1$-$C_3$ et un groupe hydroxyalkyle en $C_1$-$C_3$; d'environ 10 à environ 56 % en poids d'un dérivé de tétrahydrothiophène-1,1-dioxyde de formule

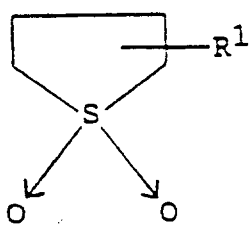

dans laquelle $R^1$ est choisi parmi l'hydrogène, un groupe méthyle et un groupe éthyle ; d'environ 3 à environ 20 % en poids de polyéthylèneglycol ; d'environ 10 à environ 30 % en poids d'un éther de monoalkyle de diéthylèneglycol de formule : $HOCH_2CH_2$-O-$CH_2CH_2$-O-$R^2$ dans laquelle $R^2$ est un groupe alkyle en $C_1$-$C_4$ ; caractérisée en ce qu'elle contient en outre d'environ 1 à environ 15 % en poids d'une amine ou d'un dérivé d'amine choisi parmi les suivants : 3-amino-1-propanol, éthanolamine, 2-(2-aminoéthylamino)éthanol, 2-amino-2-méthyl-1-propanol, isopropanolamine, 2-amino-3-picoline, 2-amino-4-nitrophénol, 2-amino-6-picoline, morpholine, 2-aminoéthylpipérazine et 2-amino-4,6-diméthylpyrimidine.

2. Une composition selon la revendication 1, caractérisée en ce qu'elle comprend environ 45 à environ 70 % en poids d'un dérivé de 2-pyrrolidinone, d'environ 10 à environ 40 % en poids d'un dérivé de tétrahydrothiophène-1,1-dioxyde, d'environ 5 à environ 12 % en poids de polyéthylèneglycol, d'environ 12 à environ 20 % en poids d'un éther de monoalkyle de diéthylèneglycol et d'environ 2 à environ 10 % en poids d'une amine ou d'un dérivé d'amine.

3. Une composition selon la revendication 1, caractérisé en ce qu'elle comprend d'environ 45 à environ 60 % en poids du dérivé de 2-pyrrolidinone, d'environ 15 à environ 30 % en poids du dérivé de tétrahydrothiophène-1,1-dioxyde, d'environ 6 à environ 12 % en poids de polyéthylèneglycol, d'environ 15 à environ 20 % en poids d'éther de monoalkyle de diéthylèneglycol et d'environ 3 à environ 10 % en poids d'amine ou de dérivé d'amine.

4. Une composition selon l'une des revendications précédentes, caractérisée en ce que le dérivé de 2-pyrrolidinone est la 1-méthyl-2-pyrrolidinone, le dérivé de tétrahydrothiophène-1,1-dioxyde est le tétrahydrothiophène-1,1-dioxyde, l'éther de monoalkyle de diéthylèneglycol est le 2-(2-éthoxyéthoxy)-éthanol et l'amine ou le dérivé d'amine est choisi parmi le 1-amino-2-propanol, l'éthanolamine et le 2-(2-aminoéthylamino)éthanol.

**5.** Une composition selon la revendication 4 dans laquelle le polyéthylèneglycol est un polyéthylèneglycol d'un poids moléculaire d'environ 200.

**6.** Utilisation de la composition d'élimination selon l'une quelconque des revendications précédentes pour l'élimination d'un photorésist non exposé d'un support par mise en contact du photorésist non exposé avec ladite composition d'élimination.